# EUROPEAN PATENT APPLICATION

(11) **EP 2 515 342 A2**
(43) Date of publication of application: **24.10.2012**
(21) Application number: 12164651.7
(22) Date of filing: 18.04.2012
(51) Int. Cl.: H01L 31/0224, H01L 31/0392, H01L 31/0687, H01L 31/0725

(54) **Solar Cell**

(30) Priority: 22.04.2011 KR 20110038007
(71) Applicant: Samsung Electronics Co., Ltd., Suwon-si, Gyeonggi-do, 443-742 (KR)
(72) Inventor: Do, Eun Cheol, Yongin-si (KR); Kim, Dong Kyun, Suwon-si (KR); Kim, Yun Gi, Yongin-si (KR); Kim, Deok-Kee, Yongin-si (KR); Choi, Young Moon, Seoul (KR)
(74) Representative: Zijlstra, Robert Wiebo Johan

(57) **Abstract**

According to example embodiments, a solar cell includes a first unit portion, a second unit portion, and an insulating layer. The first and second unit portions may have different bandgaps, and the insulating layer may be between the first unit portion and the second unit portion.

## Description

### BACKGROUND

Example embodiments relate to a solar cell.

Coal and petroleum are fossil fuels that are currently used as energy sources. However, fossil fuels may cause problems such as global warming and environmental pollution. Solar light, tidal power, wind power, and geothermal heat, which do not cause environmental pollution, may be an alternative energy source for replacing fossil fuel.

Among them, technology of converting solar light into electricity takes the lead. Various materials and/or devices are being developed for the efficient conversion of solar light into electricity, and the recently proposed technologies based on the multi-layered p-n junction structure and III-V Group materials increase the conversion efficiency.

However, the above-described technology can used only for a particular wavelength of the solar light including various wavelengths for the conversion of solar light into electricity. A multi-junction structure designed to absorb the light in plural wavelengths can not provide a high conversion efficiency, because the electricity generated from the multijunction structure is not used efficiently.

### SUMMARY OF THE INVENTION

A solar cell according to example embodiments includes a first unit portion, a second unit portion, an insulating layer disposed between the first unit portion and the second unit portion, and a plurality of electrical terminals including a first pair of terminals and a second pair of terminals, wherein the first pair of terminals are electrically connected to the first unit portion, and wherein the second pair of terminals are electrically connected to the second unit portion.

The first unit portion may have a first bandgap and the second unit portion may have a second bandgap, wherein the first bandgap may be smaller than the second bandgap.

A difference between the first bandgap and the second bandgap may be in a range from about 0.3 eV to about 0.8 eV

The first bandgap may be in a range from about 0.4 eV to about 1.5 eV, and the second bandgap may be in a range from about 1.0 eV to about 2.5 eV

The first bandgap may be in a range from about 0.6 to about 0.7 eV, and the second bandgap may be in a range from about 1.0 eV to about 1.2 eV

The first bandgap may be in a range from about 1.0 to about 1.2 eV, and the second bandgap may be in a range from about 1.6 eV to about 1.8 eV

The first unit portion may include Ge, and the second unit portion may include one of crystalline silicon and Cu-In-Se (CIS).

The first unit portion may include one of crystalline silicon and Cu-In-Se (CIS), and the second unit portion may include one of amorphous silicon, Cu-Ga-Se (CGS) and polymer.

The first unit portion, the insulating layer and the second unit portion may be stacked, and the first pair of terminals may be on one side of the insulating layer and the second pair of terminals may be on another side of the insulating layer.

The first pair of terminals may include a first positive terminal and a first negative terminal, and the first positive and negative terminals may be connected to a same side of the first unit portion.

The second pair of terminals may include a second positive terminal and a second negative terminal, and the second positive and negative terminals may be connected to a same side of the second unit portion.

The second pair of terminals may include a second positive terminal and a second negative terminal, and the second positive may be connected to one side of the second unit portion and the second negative terminal may be connected to another side of the second unit portion.

The first pair of terminals may include a first positive terminal and a first negative terminal, and the first positive may be connected to one side of the first unit portion and the first negative terminal may be connected to another side of the first unit portion.

The second pair of terminals may include a second positive terminal and a second negative terminal, and the second positive and negative terminals may be connected to a same side of the second unit portion.

The second pair of terminals may include a second positive terminal and a second negative terminal, and the second positive terminal may be connected to one side of the second unit portion and the second negative terminal may be connected to another side of the second unit portion.

The first unit portion may include a crystalline silicon substrate, and the second unit portion may include one of CdTe and Cu-In-Ga-Se (CIGS).

At least one of the first unit portion and the second unit portion may include a P-type region and an N-type region, and each of the P-type region and the N-type region may be electrically connected to one of the terminals.

At least one of the first unit portion and the second unit portion may include a transparent electrode layer and a textured surface.

According to example embodiments, a solar cell includes a plurality of unit portions sequentially stacked, and at least one insulating layer disposed between neighboring unit portions, wherein each of the plurality of unit portions includes a bandgap, and the bandgaps of the plurality of unit portions are different from each other, and each of the plurality of unit portions is electrically connected to a pair of electrical terminals.

The bandgaps of the plurality of unit portions may increase from bottom to top.

The plurality of unit portions may include a first unit portion, a second unit portion, and a third unit portion, wherein a bandgap of the first unit portion may be in a range from about 0.6 eV to about 0.7 eV, a bandgap of the second unit portion may be in a range from about 1.0 eV to about 1.2 eV; and a bandgap of the third unit portion may be in a range from about 1.6 eV to about 1.8 eV

A first unit portion of the plurality of unit portions may include one of crystalline silicon and Cu-In-Se (CIS), and a second unit portion of the plurality of unit portions may include one of amorphous silicon, Cu-Ga-Se (CGS) and polymer.

The pair of electrical terminals of each unit portion may include a positive terminal and a negative terminal, and each of the positive and negative terminals may be electrically connected to one of a P-type region and an N-type region.

At least one of the plurality of unit portion may have positive and negative terminals connected to opposing sides of the at least one unit portion.

At least one of the plurality of unit portions may include a transparent electrode layer and a textured surface.

### BRIEF DESCRIPTION OF THE DRAWINGS

The foregoing and other features and advantages of example embodiments will be apparent from the more particular description of non-limiting embodiments, as illustrated in the accompanying drawings in which like reference characters refer to the same parts throughout the different views. The drawings are not necessarily to scale, emphasis instead being placed upon illustrating the principles of example embodiments. In the drawings:
FIG. 1 is schematic sectional view of a solar cell according to example embodiments.
FIGS. 2 and 3 are graphs showing photo current density generated by solar cells according to example embodiments as function of wavelength of solar light.
FIGS. 4 to 15 are sectional views of solar cells according to example embodiments.

### DETAILED DESCRIPTION

Example embodiments will be described more fully hereinafter with reference to the accompanying drawings, in which some example embodiments are shown. Example embodiments may, however, be modified in various different ways and should not be construed as being limited to the embodiments set forth herein; rather, these example embodiments are provided so that this disclosure will be thorough and complete, and will fully convey concepts of example embodiments to those of ordinary skill in the art. In the drawings, the thicknesses of layers and regions are exaggerated for clarity. Like reference numerals in the drawings denote like elements, and thus their description will be omitted. In the drawing, parts having no relationship with the explanation are omitted for clarity.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. As used herein the term "and/or" includes any and all combinations of one or more of the associated listed items. Other words used to describe the relationship between elements or layers should be interpreted in a like fashion (e.g., "between" versus "directly between," "adjacent" versus "directly adjacent," "on" versus "directly on").

It will be understood that, although the terms "first", "second", etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, a first element, component, region, layer or section discussed below could be termed a second element, component, region, layer or section without departing from the teachings of example embodiments.

Spatially relative terms, such as "beneath," "below," "lower," "above," "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the exemplary term "below" can encompass both an orientation of above and below. The device may be otherwise oriented (rotated 90 degrees or at other orientations) and the spatially relative descriptors used herein interpreted accordingly.

The terminology used herein is for the purpose of describing particular embodiments only and is not intended to be limiting of example embodiments. As used herein, the singular forms "a," "an" and "the" are intended to include the plural forms as well, unless the context clearly indicates otherwise. It will be further understood that the terms "comprises", "comprising", "includes" and/or "including," if used herein, specify the presence of stated features, integers, steps, operations, elements and/or components, but do not preclude the presence or addition of one or more other features, integers, steps, operations, elements, components and/or groups thereof.

Example embodiments are described herein with reference to cross-sectional illustrations that are schematic illustrations of idealized embodiments (and intermediate structures) of example embodiments. As such, variations from the shapes of the illustrations as a result, for example, of manufacturing techniques and/or tolerances, are to be expected. Thus, example embodiments should not be construed as limited to the particular shapes of regions illustrated herein but are to include deviations in shapes that result, for example, from manufacturing. For example, an implanted region illustrated as a rectangle may have rounded or curved features and/or a gradient of implant concentration at its edges rather than a binary change from implanted to non-implanted region. Likewise, a buried region formed by implantation may result in some implantation in the region between the buried region and the surface through which the implantation takes place. Thus, the regions illustrated in the figures are schematic in nature and their shapes are not intended to illustrate the actual shape of a region of a device and are not intended to limit the scope of example embodiments.

Unless otherwise defined, all terms (including technical and scientific terms) used herein have the same meaning as commonly understood by one of ordinary skill in the art to which example embodiments belong. It will be further understood that terms, such as those defined in commonly-used dictionaries, should be interpreted as having a meaning that is consistent with their meaning in the context of the relevant art and will not be interpreted in an idealized or overly formal sense unless expressly so defined herein.

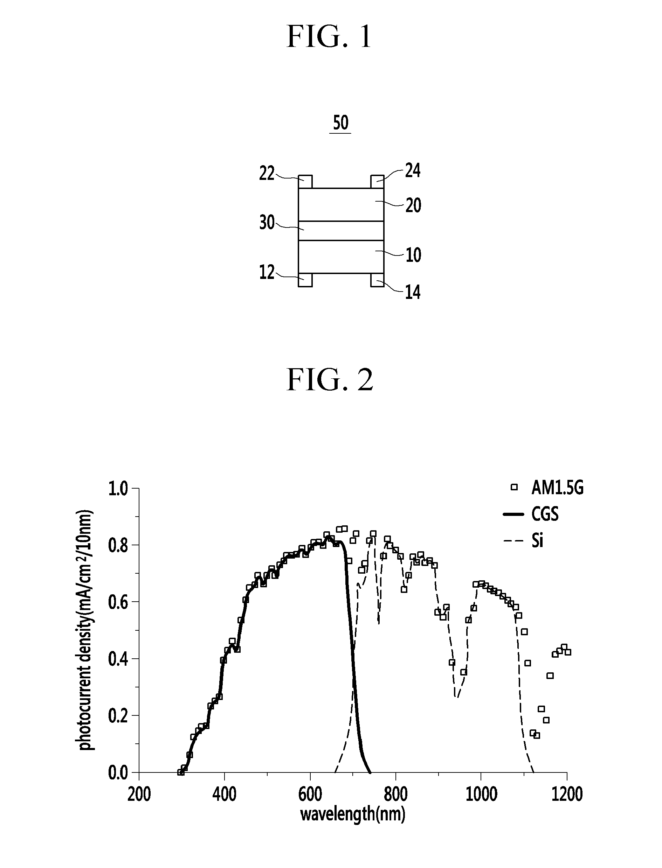

Referring to FIGS. 1 to 3, a solar cell according to example embodiments is described.

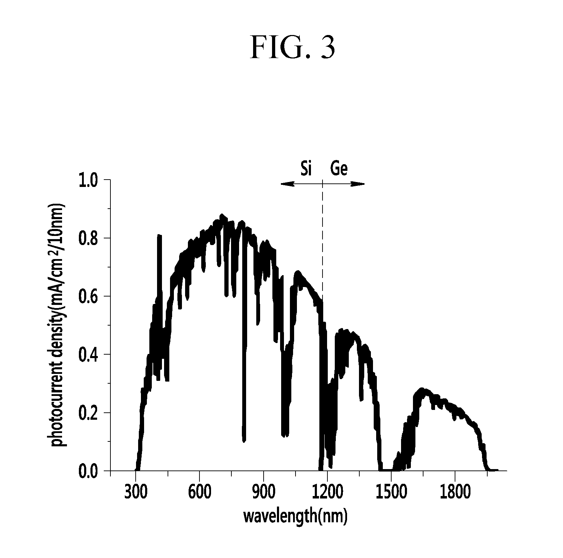

FIG. 1 is schematic sectional view of an solar cell according to example embodiments, and FIGS. 2 and 3 are graphs showing photo current density generated by a solar cell according to example embodiments as function of wavelength of solar light.

A solar cell 50 according to example embodiments may include two unit portions, a lower unit portion 10 and an upper unit portion 20 stacked in sequence, and an insulating layer 30 may be disposed between the unit portions 10 and 20. The insulating layer 30 may electrically separate the lower unit portion 10 and the upper unit portion 20, and may include, for example a dielectric material such as SiO₂, but example embodiments are not limited thereto. For example, the insulating layer 30 alternatively may include silicon nitride, a transparent insulating polymer, a gas or liquid layer and the like, but example embodiments are not limited thereto.

The lower and upper unit portions 10 and 20 include photoelectric material that can generate electricity upon receipt of light. Materials for the lower unit portion 10 and for the upper unit portion 20 may have different energy bandgaps. For example, the bandgap of the upper unit portion 20 may be greater than that of the lower unit portion 10, and the difference in the bandgap between the lower unit portion 10 and the upper unit portion 20 may be about 0.3 to about 0.8 eV If the bandgap difference between the unit portions 10 and 20 is lower than 0.3 eV or greater than 0.8 eV, an available wavelength range of light may decrease or an output voltage may not be optimized, thereby reducing the efficiency of power generation. The bandgap of the lower unit portion 10 may be about 0.4 eV to about 1.5 eV, while the bandgap of the upper unit portion 20 may be about 1.0 eV to about 2.5 eV

Examples of photoelectric materials for the unit portions 10 and 20 include various polymers and semiconductors such as Si, Ge, Cu-In-Ga-Se (CIGS), CdTe, GaSb, InAs, PbS, GaP, ZnTe, CdS, AlP, and/or GaAs, but example embodiments are not limited thereto. Crystalline silicon (Si), such as polycrystalline or single-crystalline silicon (Si), may have a bandgap of about 1.1 eV to about 1.2 eV, while amorphous silicon (Si) may have a higher bandgap of about 1.6 eV to about 1.7 eV Germanium (Ge) may have a bandgap of about 0.6 eV to about 0.7 eV, and CdTe and GaAs may have a bandgap of about 1.4 eV to about 1.5 eV GaSb may have a bandgap of about 0.7 eV, and InAs and PbS may have a bandgap of about 0.4 eV GaP and ZnTe may have bandgap of about 2.2 eV to about 2.3 eV, and CdS and AlP may have bandgap of about 2.4 eV to about 2.5 eV CIGS may have a bandgap of about 1.0 to about 1.7 eV depending on the composition ratio of In and Ga. A CIGS layer that contains mainly In but substantially no Ga, i.e., that contains Cu-In-Se as main ingredients (hereinafter referred to as "CIS") may have a bandgap of about 1.0 eV On the contrary, a CIGS layer that contains mainly Ga but substantially no In, i.e., that contains Cu-Ga-Se as main ingredients (hereinafter referred to as "CGS") may have a bandgap about 1.7 eV Polymers are known to have bandgaps of equal to or greater than about 1.7 eV

The above-described materials are classified into three groups according to the degree of the bandgap. The first group has a bandgap of about 1.0 eV to about 1.2 eV and may include crystalline silicon such as poly-crystalline silicon and/or single-crystalline silicon and Cu-In-Se (CIS). The second group has a bandgap equal to or greater than about 1.4 eV and may include amorphous silicon, CGS, CdTe, GaAs, GaP, ZnTe, CdS, AlP, and polymer. The last group has a bandgap equal to or lower than about 0.7 eV and may include Ge, GaSb, InAs, and PbS.

Among the three groups, the second group may be used mainly for the upper unit portion 20, while the last group mainly for the lower unit portion 10. The first group may be used for either the lower unit portion 10 or the upper unit portion 20 as the case may be. However, the usage is not limited thereto, and each of the groups may be used either the lower unit portion 10 or the upper unit portion 20 depending on the relative degree of the bandgap.

For example, when crystalline silicon and/or CIS in the first group is used for the upper unit portion 20, Ge in the last group may be used for the lower unit portion 10. On the contrary, when crystalline silicon and/or CIS in the first group is used for the lower unit portion 10, amorphous silicon, CGS, CdTe, GaAs, and/or polymer may be used for the upper unit portion 20. In this case, amorphous silicon and CGS, which have bandgaps of about 1.6 eV to about 1.8 eV, may give higher efficiency than CdTe and GaAs, which have relatively low bandgaps in the second group.

The lower and upper unit portions 10 and 20 may be formed as substrates or thin films. The thin films may be formed by chemical deposition such as chemical vapor deposition (CVD) or by physical deposition such as sputtering, but example embodiments are not limited thereto.

Among the above-described materials, a crystalline semiconductor, for example a single crystalline silicon substrate, may be used for the lower unit portion 10 due to its stable characteristics and relatively easy fabrication process. In this case, the insulating layer 30 may be deposited on the lower unit portion 10 by CVD or by other lamination process, and then a thin film of another photoelectric material such as CdTe or CIGS may be deposited on the insulating layer 30 to form the upper unit portion 20.

Each of the lower and upper unit portions 10 and 20 may include a pair of terminals 12, 14, 22, and 24 that may include a low resistance metal such as Cu, Ag and etc. In detail, a pair of lower terminals 12 and 14 are disposed under the lower unit portion 10, and a pair of upper terminals 22 and 24 are disposed on the upper unit portion 20. Therefore, the current flowing in each of the lower and upper unit portions 10 and 20 flows outward through respective terminals 12 and 14 or 22 and 24. The current in the lower unit portion 10 flows outward through the lower terminals 12 and 14, while the current in the upper unit portion 20 flows through the upper terminals 22 and 24. However, since the lower unit portion 10 and the upper unit portion 20 are electrically isolated from each other, the current from the lower unit portion 10 may not pass through the upper terminals 22 and 24, and the current from the upper unit portion 20 may not pass through the lower terminals 12 and 14.

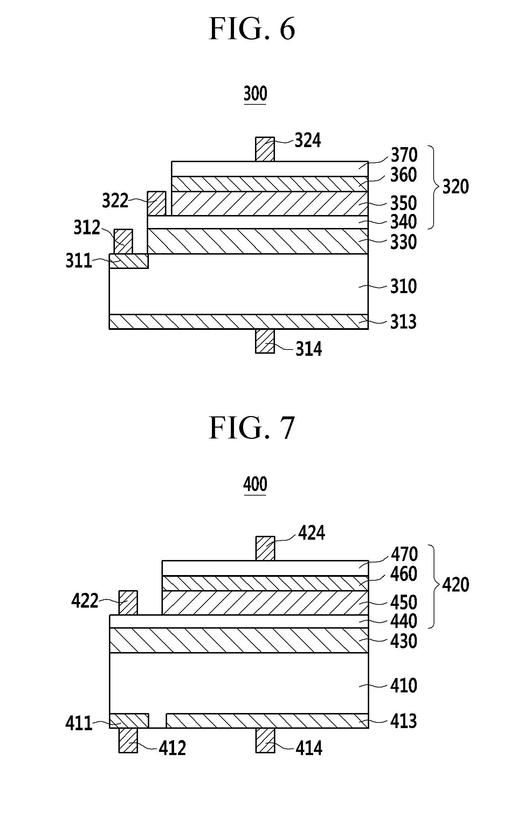

The positions of the terminals 12, 14, 22, and 24 may not be limited to those shown in FIG. 1, and the terminals 12, 14, 22, and 24 may be disposed at various other locations. For example, at least one of the lower terminals 12 and 14 may be disposed on an upper surface of the lower unit portion 10. In this case, a portion of the upper surface of the lower unit portion 10 may be opened in order to accommodate the at least one of the lower terminals 12 and 14 as shown in FIG. 6.

When the upper unit portion 20 includes a material having a relatively high energy bandgap and the lower unit portion 10 includes a material having a relatively low bandgap, light with a relatively short wavelength among solar light may be absorbed into the upper unit portion 20 and generate a current with a high voltage. On the other hand, light with a relatively long wavelength may be absorbed into the lower unit portion 10 and generate a current with a relatively low voltage.

Referring to FIG. 2, when the upper unit portion 20 includes CGS and the lower unit portion 10 includes single crystalline silicon, the upper unit portion 20 may absorb the light whose wavelength is in a range lower than about 700 nm to generate a current with a relatively high voltage, and the lower unit portion 10 may absorb the light whose wavelength is in a range of about 700 nm to about 1,100 nm to generate a current with a relatively low voltage.

Referring to FIG. 3, when the upper unit portion 20 includes single crystalline silicon and the lower unit portion 10 includes Ge, the upper unit portion 20 may absorb the light whose wavelength is in a range lower than about 1,100 nm to generate a current with a relatively high voltage, and the lower unit portion 10 may absorb the light whose wavelength is in a range of about 1,100 nm to about 1,800 nm to generate a current with a relatively low voltage.

In the above-described solar cell 50, the magnitude of the current generated by the lower unit portion 10 may be different from the magnitude of the current generated by the upper unit portion 20. In this case, if the upper unit portion 20 and the lower unit portion 10 are electrically connected to each other, a net current of the solar cell may be determined by a lower current among the currents generated by the upper unit portion 20 and the lower unit portion 10. Therefore, an excess amount of the current generated by one of the unit portions 10 and 20 may not be utilized, and this may reduce the efficiency of the solar cell. However, according to example embodiments, the upper unit portion 20 and the lower unit portion 10 are electrically separated. Therefore, the currents having different magnitudes and generated by the upper unit portion 20 and the lower unit portion 10 can be collected separately and used without current loss, thereby it may increase the efficiency of the solar cell.

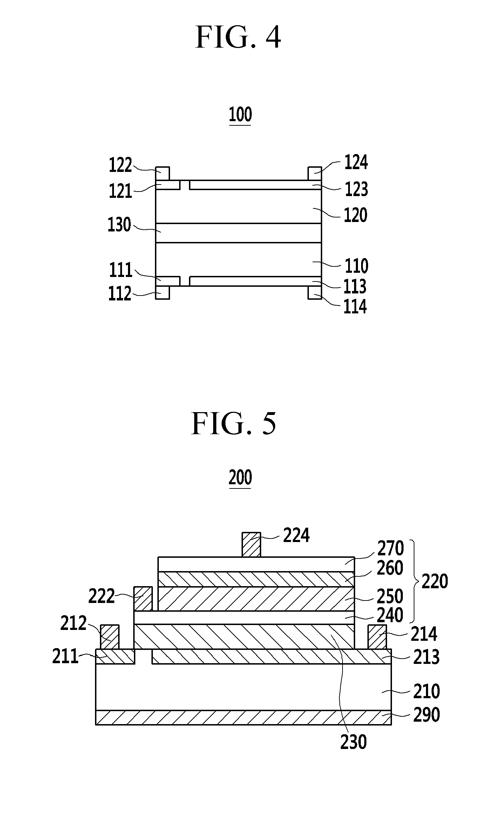

Next, various solar cells according to example embodiments are described in detail with reference to FIGS. 4 to 8.

FIGS. 4 to 8 are sectional views of solar cells according to example embodiments.

FIG. 4 shows a solar cell 100 that includes a lower unit portion 110, an upper portion 120, and an insulating layer 130 in between. The lower unit portion 110 may include a Ge substrate, and the upper unit portion 120 may include crystalline silicon such as a P-type crystalline silicon substrate. The lower unit portion 110 may have an area that is the same as or substantially the same as the upper unit portion 120. The lower unit portion 110 may include terminals 112 and 114 thereunder, while the upper unit portion 120 may includes terminals 122 and 124 thereon.

Near or on a lower surface of the lower unit portion 110, a P-type region 111 containing P-type impurity and an N-type region 113 containing N-type impurity may be formed. The P-type region 111 is connected to a positive terminal 112, while the N-type region 113 is connected to a negative terminal 114.

A P-type region 121 containing P-type impurity and an N-type region 123 containing N-type impurity may be formed near or on an upper surface of the upper unit portion 120. The P-type region 121 is connected to a positive terminal 122, while the N-type region 123 is connected to a negative terminal 124. The N-type region 123 may have a larger area than the P-type region 121.

In FIG. 4, the terminals 112, 114, 122, and 124 may be disposed on peripheries of respective unit portions 110 and 120, but their positions are not limited thereto.

FIG. 5 shows a solar cell 200 where an insulating layer 230 is disposed on a lower unit portion 210 including a crystalline silicon substrate, and an upper unit portion 220 including a photoelectric material such as CdTe or CIGS is formed on the insulating layer 230. The upper unit portion 220 may include a P-type layer 250 including CdTe or CIGS and an N-type layer 260 that is disposed on the P-type layer 250 and includes CdS or ZnS, etc. The upper unit portion 220 may further include a lower electrode 240 disposed under the P-type layer 250, and an upper electrode 270 disposed on the N-type layer 260. The lower and upper electrodes 240 and 270 may include a transparent conductive material, for example, indium-tin-oxide (ITO), zinc oxide, indium zinc oxide (IZO), indium oxide, tin oxide, titanium oxide, and/or cadmium oxide, but example embodiments are not limited thereto. The electrodes 240 and 270 may serve as electrical connections between the terminals 222 and 224 and the P-type layer 250 and the N-type layer 260. Furthermore, there may be formed a passivation layer 290 that is disposed under the lower unit portion 210 and reduces and/or prevents the electrical loss in the lower unit portion 210.

Each of the insulating layer 230 and the upper unit portion 220 has an area smaller than the lower unit portion 210 such that portions of the lower unit portion 210, for example both peripheries of the lower unit portion 210, may not be covered by the insulating layer 230. Terminals 212 and 214 for the lower unit portion 210 may be formed on the exposed (i.e. uncovered) portion of the lower unit portion 210. The exposed portion of the upper surface of the lower unit portion 210 may include a P-type region 211 containing P-type impurity and an N-type region 213 containing N-type impurity near or on the upper surface of the lower unit portion 210. A positive terminal 212 and a negative terminal 214 for the lower unit portion 210 may be connected to the P-type and N-type regions 211 and 213, respectively.

Referring to Fig. 5, a lower electrode 240 of the upper unit portion 220 is disposed on the insulating layer 230. The P-type layer 250, the N-type layer 260, and the upper electrode 270 of the upper unit portion 220 are disposed on the lower electrode 240. Each of the layers 250, 260 and 270 may be smaller than the lower electrode 240, and thus a portion of the lower electrode 240 may be exposed. A positive terminal 222 for the upper unit portion 220 may be disposed on the exposed portion of the lower electrode 240. A negative terminal 224 for the upper unit portion 220 may be disposed on the upper electrode 270.

In FIG. 5, the negative terminal 224 for the upper unit portion 220 is disposed at a center of the upper unit portion 220. The terminals 212 and 214 are disposed near both edges of the lower unit portion 210. The terminal 222 is near an edge of the lower electrode 240. However, the terminals positions are not limited thereto.

FIG. 6 shows a solar cell 300 where an insulating layer 330 is disposed on a lower unit portion 310 of, for example, a crystalline silicon substrate. An upper unit portion 320 of, for example, a quad-layered structure, may include a lower electrode 340, a P-type layer 350, an N-type layer 360, and an upper electrode 370, like the solar cell shown in FIG. 5. The P-type layer 350 may include CdTe or CIGS, and the N-type layer 360 may include CdS or ZnS.

However, unlike the solar cell shown in FIG. 5,only an edge portion of the lower unit portion 310 may be exposed (i.e. uncovered) by the insulating layer 330. One of terminals 312 and 314 for the lower unit portion 310, for example a positive terminal 312, may be disposed on the exposed portion of an upper surface of the lower unit portion 310. The other terminal, for example the negative terminal 314, of the lower unit portion 310 may be disposed on a lower surface of the lower unit portion 310. Hence, a P-type region 311 of the lower unit portion 310 may be formed near or on the upper surface of the lower unit portion 310, while an N-type region 313 may be formed near or on the lower surface of the lower unit portion 310.

In the upper unit portion 320, a positive terminal 322 for the upper unit portion 320 may be disposed on an exposed portion of an upper surface of the lower electrode 340, while the negative terminal 324 for the upper unit portion 320 may be disposed on the upper electrode 370.

As shown in FIG. 6, the positive terminal 312 for the lower unit portion 310 and the positive terminal 322 for the upper unit portion 320 may be disposed near edges of the lower unit portions 310 and the lower electrode 340 respectively. On the other hand, the negative terminal 314 for the lower unit portion 310 and the negative terminal 324 for the upper unit portion 320 may be disposed near the center of the lower unit portion 310 and the center of the upper electrode 370, respectively. However, the positions of the terminals 312, 314, 322, and 324 are not limited thereto, and may be changed.

FIG. 7 shows a solar cell 400 where an insulating layer 430 is disposed on a lower unit portion 410 of, for example, a crystalline silicon substrate. An upper unit portion 420 of, for example, a quad-layered structure, may include a lower electrode 440, a P-type layer 450, an N-type layer 460, and an upper electrode 470, like the solar cells shown in FIGS. 5 and 6. The P-type layer 450 may include CdTe or CIGS, and the N-type layer 460 may include CdS or ZnS.

However, unlike the solar cells shown in FIGS. 5 and 6, terminals 412 and 414 for the lower unit portion 410 are disposed on a lower surface of the lower unit portion 410, and the insulating layer 430 is placed on an upper surface of the lower unit portion 410 without an exposed portion. Terminals 422 and 424 for the upper unit portion 420 are disposed on the upper unit portion 420 positioned above the insulating layer 430.

In detail, regarding the lower unit portion 410, a P-type region 411 and an N-type region 413 are disposed near a lower surface of the lower unit portion 410. The P-type region 411 is connected to a positive terminal 412, and the N-type region 413 is connected to a negative terminal 414, like the solar cell shown in FIG. 4.

Regarding the upper unit portion 420, a positive terminal 422 for the upper unit portion 420 may be disposed on an exposed portion of a top surface of the lower electrode 440, and the negative terminal 424 for the upper unit portion 420 may be disposed on the upper electrode 470, like the solar cells shown in FIGS. 5 and 6.

In case of FIG. 7, the positive terminal 412 for the lower unit portion 410 and the positive terminal 422 for the upper unit portion 420 may be disposed near edges of the lower unit portion 410 and the lower electrode 440, respectively. The negative terminal 414 for the lower unit portion 410 and the negative terminal 424 for the upper unit portion 420 may be disposed near the center of the lower unit portions 410 and the upper electrode 470, like the solar cell shown in FIG. 6. However, the positions of the terminals 412, 414, 422, and 424 are not limited thereto, and may be changed.

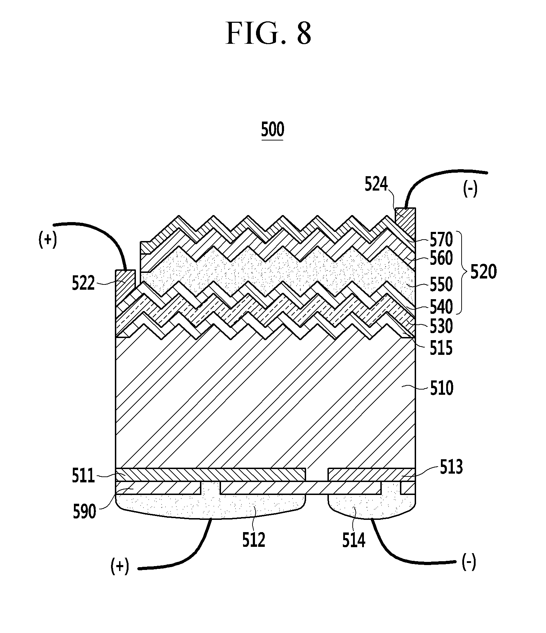

FIG. 8 shows a solar cell 500 that has a structure similar to that of the solar cell shown in FIG. 7. In detail, an insulating layer 530 is disposed on a lower unit portion 510 of, for example, a crystalline silicon substrate. An upper unit portion 520 of, for example, a quad-layered structure, may include a lower electrode 540, a P-type layer 550, an N-type layer 560, and an upper electrode 570. The P-type layer 550 may include CdTe or CIGS, and the N-type layer 460 may include CdS or ZnS. Terminals 512 and 514 for the lower unit portion 510 are disposed under the lower unit portion 510, and terminals 522 and 524 of the upper unit portion 520 are disposed on the upper unit portion 520.

However, unlike the solar cell shown in FIG. 7, an upper surface of the lower unit portion 510 may be textured. Therefore, the insulating layer 530 and the upper unit portion 520 disposed on the lower unit portion 510 are curved and textured along the textures on the upper surface of the lower unit portion 510. Due to the textures, a portion of the light incident on the textured upper surface of the upper unit portion 520 may be reflected into the interior of the upper unit portion 520, and thereby it may increase the amount of light absorbed by the solar cell. The textured surface of the lower unit portion 510 may be formed by, for example, treating the surface of the lower unit portion 510 using an etchant such as KOH, etc.

Referring to FIG. 8, the lower unit portion 510 may include high-concentration impurity regions, i.e., a P-type region 511 and an N-type region 513. A blocking region 515 containing N-type impurity of low concentration may be further included in the lower unit portion 510 and disposed near a boundary to the insulating layer 530. The blocking region 515 may reduce recombination of holes and electrons at the boundary, where the holes and electrons are generated in the lower unit portion 510.

An insulating layer 590 that may include SiO₂, silicon nitride, or a transparent insulating polymer etc., may be disposed between a lower surface of the lower unit portion 510 and terminals 512 and 514 for the lower unit portion 510. The insulating layer 590 may also reduce recombination of holes and electrons like the blocking region 515 disposed at an upper part of the lower unit portion 510.

The insulating layer 590 may have a plurality of contact holes exposing the P-type region 511 and the N-type region 513, and the terminals 512 and 514 for the lower unit portion 510 are connected to the impurity regions 511 and 513 through the contact holes. However, a barrier layer (not shown) that may include a material such as TiN, etc., may be disposed on portions of bottom surfaces of the impurity regions 511 and 513 exposed through the contact holes.

The terminals 512 and 514 for the lower unit portion 510 may be formed by, for example, plating a material such as Cu, and the terminals 522 and 524 for the upper unit portion 520 may be formed by, for example, printing Ag paste, etc.

A substrate for the lower unit portion 510 may be N-type instead of P-type. When the substrate is N-type, the P-type region 511 of the lower unit portion 510 may be larger than the N-type region 513 as shown in FIG. 8.

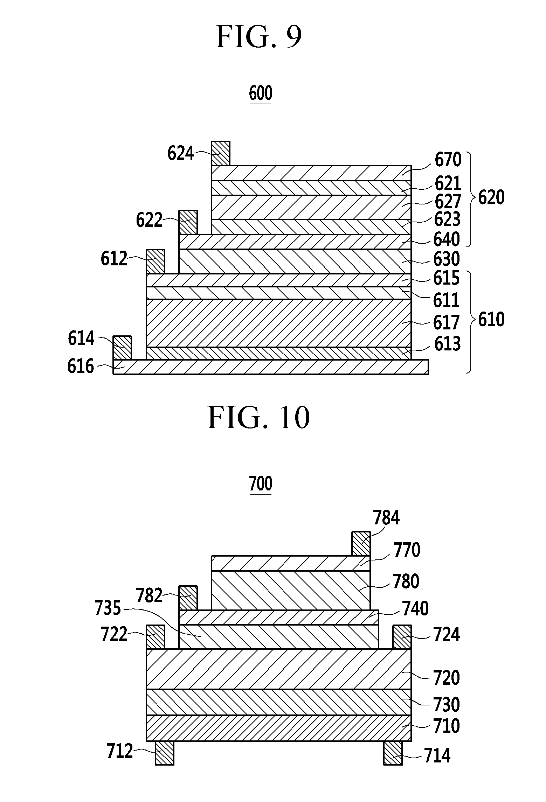

FIG. 9 shows a solar cell 600 where an insulating layer 630 is between a lower unit portion 610 and an upper unit portion 620. The lower unit portion 610 in FIG. 9 includes a p-i-n junction (or alternatively an n-i-p junction) sequentially formed and the upper unit portion 620 includes a p-i-n junction (or alternatively an n-i-p junction) sequentially formed.

The lower unit portion 610 may include a crystalline silicon substrate 617, such as poly-crystalline silicon and/or single-crystalline silicon, a p-type impurity region 611 formed in an upper portion of the substrate 617, and an n-type impurity region 613 formed in a lower portion of the substrate 617. Alternatively, the n-type impurity region 613 may be formed in the upper portion of the substrate 617 and the p-type impurity region 611 may be formed in the lower portion of the substrate 617. The lower unit portion 610 may further include a pair of terminals 612 and 614 that may be connected to the p-type impurity region 611 and the n-type impurity region 613 through an upper electrode 615 and a lower electrode 616 respectively. The upper electrode 615 and the lower electrode 616 may include a transparent conductive material, such as ITO, zinc oxide, indium zinc oxide (IZO), indium oxide, tin oxide, titanium oxide, and/or cadmium oxide, but example embodiments are not limited thereto. In the alternative, the lower electrode 616 may include a metal and/or transparent conductive material.

The upper unit portion 620 may include an amorphous silicon substrate 627, a p-type impurity region 621 formed in an upper portion of the substrate 627, and an n-type impurity region 623 formed in a lower portion of the substrate 627. Alternatively, the n-type impurity region 623 may be formed in the upper portion of the substrate and the p-type impurity region 621 may be formed in the lower portion of the substrate 617. The upper unit portion 620 may further include a pair of terminals 622 and 624 that may be connected to the p-type impurity region 621 and the n-type impurity region 623 through an upper electrode 670 and a lower electrode 640 respectively. The pair of terminals 622 and 624 may include a low resistance metal such as Cu and Ag. The upper electrode 670 and the lower electrode 640 may include a transparent conductive material, such as ITO, zinc oxide, indium zinc oxide (IZO), indium oxide, tin oxide, titanium oxide, and/or cadmium oxide, but example embodiments are not limited thereto. While FIG. 9 illustrates a solar cell 600 where the upper unit portion 620 and the lower unit portion 610 include a non-textured surface, example embodiments are not limited thereto, and the upper unit portion 620 and the lower unit portion 610 may be treated to form textured surfaces in order to increase light absorption.

Although each of the above-described solar cells 50, 100, 200, 300, 400, 500, and 600 include two unit portions, three or more unit portions having different energy bandgaps can be stacked with interposing insulating layers. In this case, the energy bandgap may increase from the bottom to the top. When the number of unit portions is three, the first group having an intermediate bandgap among the above-described three groups may used for a middle unit portion, the second group having a high bandgap for an upper unit portion, and the third group having a low bandgap for a lower unit portion.

For example, FIG. 10 illustrates a solar cell 700 including a first unit portion 710, a second unit portion 720, and a third unit portion 780 stacked in sequence. A first insulating layer 730 may be between the first unit portion 710 and the second unit portion 720 in order to electrically separate the first unit portion 710 and the second unit portion 720. A second insulating layer 735 may be between the second unit portion 720 and the third unit portion 780 in order to electrically separate the second unit portion 720 and the third unit portion 780. Both the first insulating layer 730 and the second insulating layer 735 may be made of a dielectric material, such as SiO₂, but example embodiments are not limited thereto. For example, the insulating layers 730 and 735 alternatively may include silicon nitride or a transparent insulating polymer, and the like, but example embodiments are not limited thereto.

The first unit portion 710 may include a photoelectric material having a bandgap equal to or lower than about 0.7 eV, such as Ge, GaSb, InAs, and PbS. The second unit portion 720 may include a photoelectric material having a bandgap of about 1.0 eV to about 1.2 eV, and may include poly-crystalline silicon, monocrystalline silicon, and/or CIS, but example embodiments are not limited thereto. The third unit portion 780 may include a photoelectric material having a bandgap equal to or greater than about 1.4 eV, and may include amorphous silicon, CIGS, CGS, CdTe, GaAs, GaP, ZnTe, CdS, AlP, and/or polymer, but example embodiments are not limited thereto.

Each of the unit portions 710, 720, and 780 may include a pair of terminals, 712, 714, 722, 724, 782, and 784, that may include a low resistance metal such as Cu and Ag. A pair of terminals 712 and 714 may be connected to a lower surface of the first unit portion 610. A pair of terminals 722 and 724 may be on an upper surface of the second unit portion 720. A pair of terminals 782 and 784 may be electrically connected to the third unit portion 780 via a lower electrode 740 and an upper electrode 770 respectively. The lower and upper electrodes 740 and 770 may include a transparent conductive material, for example, ITO, zinc oxide, indium zinc oxide (IZO), indium oxide, tin oxide, titanium oxide, and/or cadmium oxide, but example embodiments are not limited thereto. The lower electrode 740 may be between the second insulating layer 735 and the third unit portion 780. The upper electrode 770 may be on the third unit portion 780.

The positions of the terminals 712, 714, 722, 724, 782, and 784 are not limited to those shown in FIG. 10 and may be modified according to features of the foregoing solar cells 100, 200, 300, 400, 500, and 600 previously described.

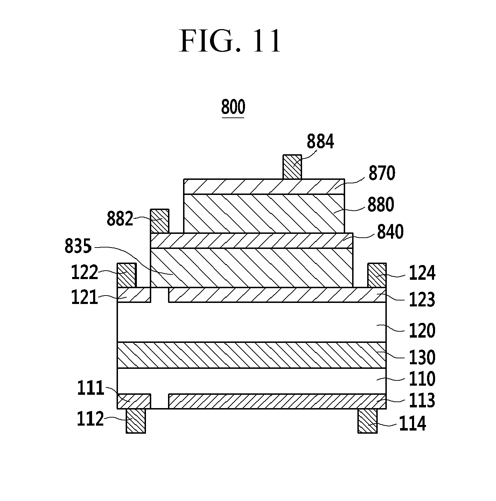

FIG. 11 illustrates a solar cell 800 including the structure of the foregoing solar cell 100 and further including a second insulating layer 835 and a third unit portion 880 formed thereon. The description of common structures in both solar cell 100 and solar cell 800 is omitted for brevity. The second insulating layer 835 may include a dielectric material such as SiO₂ silicon nitride, or a transparent insulating polymer, and the like, but example embodiments are not limited thereto.

The third unit portion 880 may be formed on the upper unit portion 120 and the third unit portion 880 may include a photoelectric material having a bandgap greater than a bandgap of the upper unit portion 120. For example, the third unit portion 880 may include amorphous silicon, CIGS, CGS, and/or polymer, but example embodiments are not limited thereto.

A pair of terminals 882 and 884 may be electrically connected to the third unit portion 880 via a lower electrode 840 and an upper electrode 870 respectively. The lower and upper electrodes 840 and 870 may include a transparent conductive material, for example, ITO, zinc oxide, indium zinc oxide (IZO), indium oxide, tin oxide, titanium oxide, and/or cadmium oxide, but example embodiments are not limited thereto. The lower electrode 840 may be between the second insulating layer 835 and the third unit portion 880. The upper electrode 870 may be on the third unit portion 880. The pair of terminals 882 and 884 may include a low resistance metal such as Cu and Ag, but example embodiments are not limited thereto.

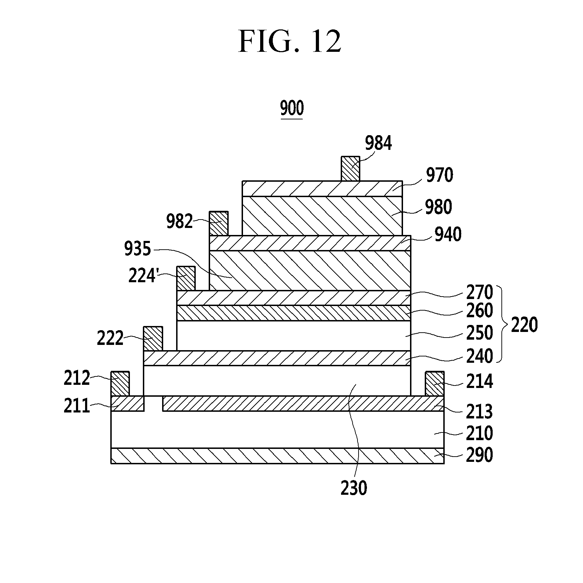

FIG. 12 illustrates a solar cell 900 including the structure of the foregoing solar cell 200 and further including a second insulating layer 935 and a third unit portion 980 formed thereon. The description of like structures in solar cell 200 and solar cell 900 are omitted for brevity. The position of the terminal 224' in FIG. 12 may be different than the position of the terminal 224 in FIG. 5 in order to accommodate the third unit portion 980. The second insulating layer 935 may include a dielectric material such as SiO₂, silicon nitride, or a transparent insulating polymer, and the like, but example embodiments are not limited thereto.

The third unit portion 980 may be formed on the upper unit portion 220 and the third unit portion 980 may include a photoelectric material having a bandgap greater than the upper unit portion 220. For example, the third unit portion 980, may include amorphous silicon, and/or polymer, but example embodiments are not limited thereto.

A pair of terminals 982 and 984 may be electrically connected to the third unit portion 980 via a lower electrode 940 and an upper electrode 970 respectively. The lower and upper electrodes 940 and 970 may include a transparent conductive material, for example, ITO, zinc oxide, indium zinc oxide (IZO), indium oxide, tin oxide, titanium oxide, and/or cadmium oxide, but example embodiments are not limited thereto. The lower electrode 940 may be between the second insulating layer 935 and the third unit portion 980. The upper electrode 970 may be on the third unit portion 980. The pair of terminals 982 and 984, and the terminal 224', may include a low resistance metal such as Cu and Ag, but example embodiments are not limited thereto.

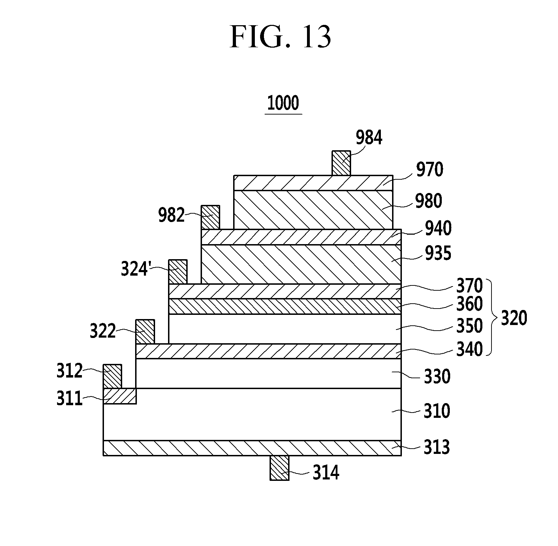

FIG. 13 illustrates a solar cell 1000 including the structure of the foregoing solar cell 300 and further including a second insulating layer 935 and a third unit portion 980 formed thereon. The description of like structures in solar cell 300, solar cell 900, and solar cell 1000 are omitted for brevity. The position of the terminal 324' in FIG. 13 is different than the position of the terminal 324 in FIG. 6 in order to accommodate the third unit portion 980. However, the terminal 324' may include the same materials as the terminal 324 in FIG. 6.

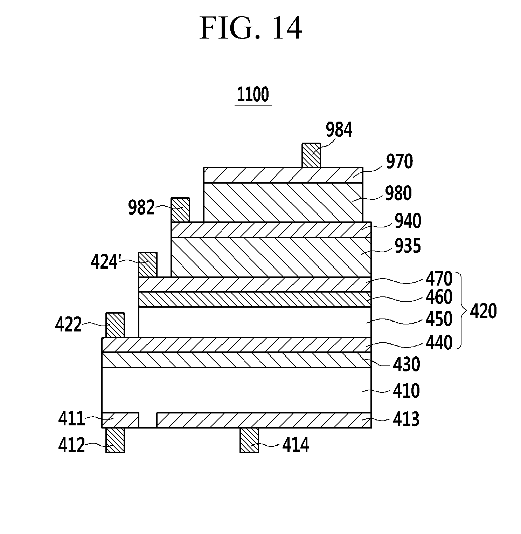

FIG. 14 illustrates a solar cell 1100 including the structure of the foregoing solar cell 400 and further including a second insulating layer 935 and a third unit portion 980 formed thereon. The description of like structures in solar cell 300, solar cell 900, and solar cell 1100 are omitted for brevity. The position of the terminal 424' in FIG. 14 is different than the position of the terminal 424 in FIG. 7 in order to accommodate the third unit portion 980. However, the terminal 424' may include the same materials as the terminal 424 in FIG. 7.

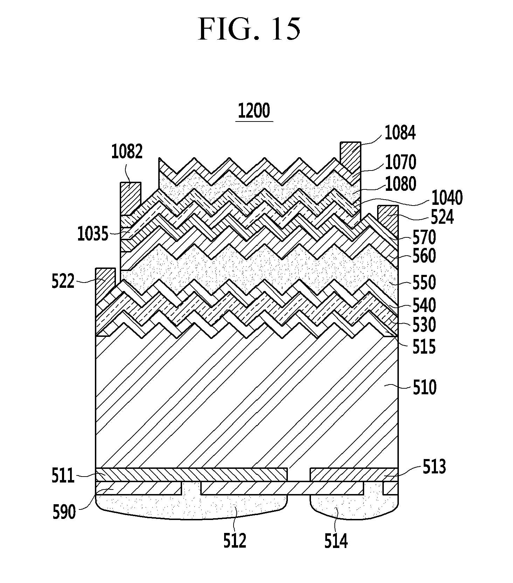

FIG. 15 illustrates a solar cell 1200 including the structure of the foregoing solar cell 500 and further including a second insulating layer 1035 and a third unit portion 1080 formed thereon. The description of like structures in solar cell 1200 and solar cell 500 is omitted for brevity. The second insulating layer 1035 may include a dielectric material such as SiO₂, silicon nitride, or a transparent insulating polymer, and the like, but example embodiments are not limited thereto.

The third unit portion 1080 may be formed on the upper unit portion 520 and the third unit portion 1080 may include a photoelectric material having a bandgap greater than a bandgap of the upper unit portion 520. For example, the third unit portion 1080, may include amorphous silicon, and/or polymer, but example embodiments are not limited thereto.

A pair of terminals 1082 and 1084 may be electrically connected to the third unit portion 1080 via a lower electrode 1040 and an upper electrode 1070 respectively. The lower and upper electrodes 1040 and 1070 may include a transparent conductive material, for example, ITO, zinc oxide, indium zinc oxide (IZO), indium oxide, tin oxide, titanium oxide, and/or cadmium oxide, but example embodiments are not limited thereto. The lower electrode 1040 may be between the second insulating layer 1035 and the third unit portion 1080. The upper electrode 1070 may be on the third unit portion 1080. The pair of terminals 1082 and 1084 may include a low resistance metal such as Cu and Ag, but example embodiments are not limited thereto.

As described above, since the unit portions having different energy bandgaps are electrically separated, the currents generated from the unit portions may be collected to be used in a whole, thereby increasing the efficiency of power generation.

While some example embodiments have been particularly shown and described, it will be understood by one of ordinary skill in the art that variations in form and detail may be made therein without departing from the scope of the appended claims.

## Claims

1. A solar cell comprising:
a first unit portion comprising a first photoelectric material;
a second unit portion comprising a second photoelectric material;
an insulating layer disposed between the first unit portion and the second unit portion; and
a plurality of electrical terminals including a first pair of terminals and a second pair of terminals,
wherein the first pair of terminals are electrically connected to the first unit portion, and
wherein the second pair of terminals are electrically connected to the second unit portion.

2. The solar cell of claim 1, wherein:
the first unit portion has a first bandgap and the second unit portion has a second bandgap, and
the first bandgap is smaller than the second bandgap.

3. The solar cell of claim 2, wherein a difference between the first bandgap and the second bandgap is in a range from about 0.3 eV to about 0.8 eV

4. The solar cell of claim 1, wherein the first photoelectric material comprises Ge, and the second photoelectric material comprises one of crystalline silicon and Cu-In-Se (CIS).

5. The solar cell of claim 1, wherein the first photoelectric material comprises one of crystalline silicon and Cu-In-Se (CIS), and the second photoelectric material comprises one of amorphous silicon, Cu-Ga-Se (CGS) and polymer.

6. The solar cell of claim 1, wherein the first photoelectric material comprises a crystalline silicon substrate, and the second photoelectric material comprises one of CdTe and Cu-In-Ga-Se (CIGS).

7. The solar cell of any of claims 1-6, wherein:
at least one of the first unit portion and the second unit portion further comprises a P-type region and an N-type region, and
each of the P-type region and the N-type region is electrically connected to one of the terminals.

8. The solar cell of any of claims 1-7, wherein at least one of the first unit portion and the second unit portion comprises a transparent electrode layer and a textured surface.

9. The solar cell of any of claims 1-8, wherein:
the first unit portion, the insulating layer and the second unit portion are stacked, and
the first pair of terminals are on one side of the insulating layer and the second pair of terminals are on another side of the insulating layer.

10. The solar cell of claim 9, wherein:
the first pair of terminals includes a first positive terminal and a first negative terminal, and
the first positive and negative terminals are connected to a same side or to different sides of the first unit portion.

11. The solar cell of claim 9 or 10, wherein:
the second pair of terminals includes a second positive terminal and a second negative terminal, and
the second positive and negative terminals are connected to a same side or to different sides of the second unit portion.

12. A solar cell according to any of claims 9-11, comprising:
a plurality of unit portions sequentially stacked; and
at least one insulating layer disposed between neighboring unit portions;
wherein each of the plurality of unit portions comprises a photoelectric material having a bandgap, and the bandgaps of the plurality of photoelectric materials are different from each other, and
wherein each of the plurality of unit portions is electrically connected to a pair of electrical terminals.

13. The solar cell of claim 12, wherein the bandgaps of the respective photoelectric materials in the plurality of unit portions increase from the bottom to the top of said stack.

14. The solar cell of claim 12 or 13, wherein:
the plurality of unit portions comprises a first unit portion, a second unit portion, and a third unit portion, and
a bandgap of the first unit portion is in a range from about 0.6 eV to about 0.7 eV, a bandgap of the second unit portion is in a range from about 1.0 eV to about 1.2 eV; and a bandgap of the third unit portion is in a range from about 1.6 eV to about 1.8 eV

15. The solar cell of claim 12, wherein the photoelectric material of a first unit portion of the plurality of unit portions comprises one of crystalline silicon and Cu-In-Se (CIS), and the photoelectric material of a second unit portion of the plurality of unit portions comprises one of amorphous silicon, Cu-Ga-Se (CGS) and polymer.

16. The solar cell of claim 12, wherein:
each of said unit portions further comprises a P-type region and an N-type region, wherein the pair of electrical terminals of each unit portion comprises a positive terminal and a negative terminal, and
each of the positive and negative terminals is electrically connected to one of the P-type region and the N-type region.
